# EUROPEAN PATENT SPECIFICATION

(11) **EP 4 446 145 B1**
(45) Date of publication and mention of the grant of the patent: **01.04.2026**
(21) Application number: 24169456.1
(22) Date of filing: 10.04.2024
(51) Int. Cl.: B60J 7/043, B60Q 3/208, B60Q 3/82

(54) **OPEN-ROOF ASSEMBLY COMPRISING A LIGHTING ASSEMBLY AND A CONTACT-FREE SWITCH THEREFOR**
DACHANORDNUNG MIT EINER BELEUCHTUNGSANORDNUNG UND EINEM KONTAKTLOSEN SCHALTER DAFÜR
ENSEMBLE TOIT OUVRANT COMPRENANT UN ENSEMBLE D'ÉCLAIRAGE ET UN COMMUTATEUR SANS CONTACT POUR CELUI-CI

(30) Priority: 12.04.2023 CN 202310389585
(43) Date of publication of application: 16.10.2024
(73) Proprietor: Inalfa Roof Systems Group B.V., 5807 GW Oostrum (NL)
(72) Inventor: Tóth, Norbert, 5627 LM Eindhoven (NL)
(74) Representative: De Vries & Metman

(56) References cited:
- EP-A1- 4 112 347
- WO-A1-2024/115260
- DE-U1- 202015 105 634

## Description

The invention relates to an open-roof assembly comprising a lighting assembly and a contact-free switch therefor. Further, the invention relates to a vehicle comprising said open-roof assembly.

An open-roof assembly is well-known. The open-roof assembly is configured to be mounted in a vehicle roof and comprises at least one moveably arranged closure member. The closure member is configured and arranged to cover an opening in the vehicle roof or at least partly uncover the opening in the vehicle roof. Usually, but not necessarily, the closure member is a transparent panel and comprises glass or a suitable plastic. The closure member may be configured to tilt or to slide.

To provide for a movement, i.e. a tilting movement or a sliding movement, of the closure member, the closure member is supported in a guide assembly. For example, the guide assembly may be adapted to raise a rear edge of the closure member to provide for a tilted position. From the tilted position, the guide assembly may be adapted to slide the closure member rearward to provide an open position, in which the opening in the vehicle roof is at least partly uncovered.

A known open-roof assembly comprises a lighting assembly. The lighting assembly may be configured to inject light into a glass panel of the closure member such that it may appear that the glass panel is lit. Other lighting assemblies are known as well such as a lighting assembly providing ring-shaped lighting below the glass panel or even below the opening in the vehicle roof.

It may be desirable to switch off the lighting assembly, when the closure member is tilted or slid to an open position, for example to prevent light distracting other drivers. This is known from DE 20 2015 105634 U1 wherein a lighting assembly is switched on or off upon connection or disconnection of physical contact points. Similarly, it is known from EP 4 112 347 A1 to provide an intermediate electrical connection of a signal label and signal detector. In an alternative to physical connections, WO 2024/115260 A1 provides a Hall sensor relying upon a magnetic element provided in the closure member. These known solutions, however, are susceptible to alignment errors.

It is an object of the present invention to provide a reliable switch for a lighting assembly of an open-roof assembly, which switch is responsive to the opening or closing of a closure member of the open-roof assembly.

In a first aspect, the object is achieved in an open-roof assembly for covering or at least partly uncovering an opening in a vehicle roof according to claim 1. The open-roof assembly comprises a moveably arranged closure member, a lighting assembly and a frame member. The lighting assembly comprises a switch device and a light source. The switch device is configured and arranged to either detect presence of a detectable part of the open-roof assembly relative to the switch device without physically contacting the detectable part, when the closure member is in a closed position covering the opening in the vehicle roof, or to detect absence of the detectable part, when the closure member is in a position at least partly uncovering the opening in the vehicle roof. The lighting assembly is configured to switch off the light source, when the switch device detects absence of the detectable part. The switch device comprises a Hall sensor and a magnetic element, wherein the magnetic element is arranged at a first side of the Hall sensor and the detectable part comprises a ferrometal. The detectable part is arranged at a second side of the Hall sensor, when the closure member is in the closed position, the second side being opposite of the first side. A Hall sensor is well-known, simple and cost-effective element to detect the presence of a magnetic field.

In a known open-roof assembly, the closure member comprises a support frame comprising a ferrometal component, e.g. comprising steel. Arranging a magnetic element at the first side of the Hall sensor, presence of a ferrometal component at the second side of the Hall sensor is detectable. The support frame may extend over a large length compared to the size of the Hall sensor. Hence, by arranging the magnetic element at the first side of the Hall sensor, placement of the Hall sensor and the detectable part may be less susceptible to alignment errors.

In an embodiment of the open-roof assembly, the lighting assembly comprises a first switch device and a second switch device, the lighting assembly being configured to switch off the light source, when either one of the first and second switch device detects absence of the detectable part. A second switch device may be used to provide redundancy and thus a more reliable operation. If one switch device would fail, the second switch device is likely to still function properly.

In an embodiment of the open-roof assembly, the switch device is arranged on the frame member, the detectable part being arranged on the closure member. In another embodiment of the open-roof assembly, the switch device is mounted on the closure member, the detectable part being arranged on the frame member. For proper operation, the switch device may be mounted either on the frame member or on the closure member and, respectively, the detectable part may be part of the closure member or be part of the frame member. Depending on the location of any electronic circuitry to operate the light source of the location of the light source itself, it may be preferred to mount the switch device on the frame member or on the closure member. In another example, a size of the switch device may be taken into consideration in view of availability of mounting space for the switch device. Other considerations may be taken into consideration instead or as well.

In an embodiment of the open-roof assembly, the frame member is arranged in a frame plane and the closure member is arranged in the frame plane, when the closure member is in the closed position. The closure member comprises a front end and a rear end, wherein the closure member is rotatable at the front end to move the rear end out of the frame plane to a tilted position. The switch device is arranged either on the rear end of the closure member or on an edge section of the frame member adjacent to the rear end of the closure member, when the closure member is in the closed position. If the light is to be switched off, when the closure member is in the tilted position, it may be suitable to arrange the switch device at a position where the closure member moves out of the frame plane to enable simple detection of the tilted position.

In an embodiment of the open-roof assembly, the frame member is arranged in a frame plane and the closure member is arranged in the frame plane, when the closure member is in the closed position. The closure member comprises a front end and a rear end, wherein the closure member is rotatable at the front end to move the rear end out of the frame plane to a tilted position, and wherein the closure member is slidable to move the closure member out of the frame plane to an open position. The switch device is arranged either on a front end of the closure member or on an edge section of the frame member adjacent to the front end of the closure member, when the closure member is in the closed position. If the light is not to be switched off, when the closure member is in the tilted position, but is to be switched off, when the closure member has slid to an open position, it may be suitable to arrange the switch device at a position where the closure member stays in the frame plane, when the closure member is in the tilted position, and where the closure member moves out of the frame plane, when the closure member slides to the open position.

In an aspect, a vehicle comprising the above-described open-roof assembly is provided.

Further scope of applicability of the present invention will become apparent from the detailed description given hereinafter, with reference to the appended schematical drawings, in which:
- Fig. 1A: shows a perspective view of a vehicle roof with an open roof assembly;
- Fig. 1B: shows an exploded view of the open roof assembly of Fig. 1A;
- Fig. 2A: shows a schematic perspective view of an open-roof assembly with a closure member in a closed position;
- Fig. 2B: shows a schematic perspective view of the open-roof assembly of Fig. 2A with the closure member in a tilted position;
- Fig. 2C: shows a schematic perspective view of the open-roof assembly of Fig. 2A with the closure member in an open position;
- Fig. 3A: shows a schematic cross-sectional view of a closure member and a guide assembly of an example not being part of the present invention;
- Fig. 3B: shows a schematic cross-sectional view of the closure member and the guide assembly of an example not being part of the present invention;
- Fig. 4A: shows a schematic cross-sectional view of a closure member and a guide assembly of an open-roof assembly according to the invention with a closure member in the closed position; and
- Fig. 4B: shows a schematic cross-sectional view of a closure member and a guide assembly of an example not being part of the present invention.

The present invention will now be described with reference to the accompanying drawings, wherein the same reference numerals have been used to identify the same or similar elements throughout the several views.

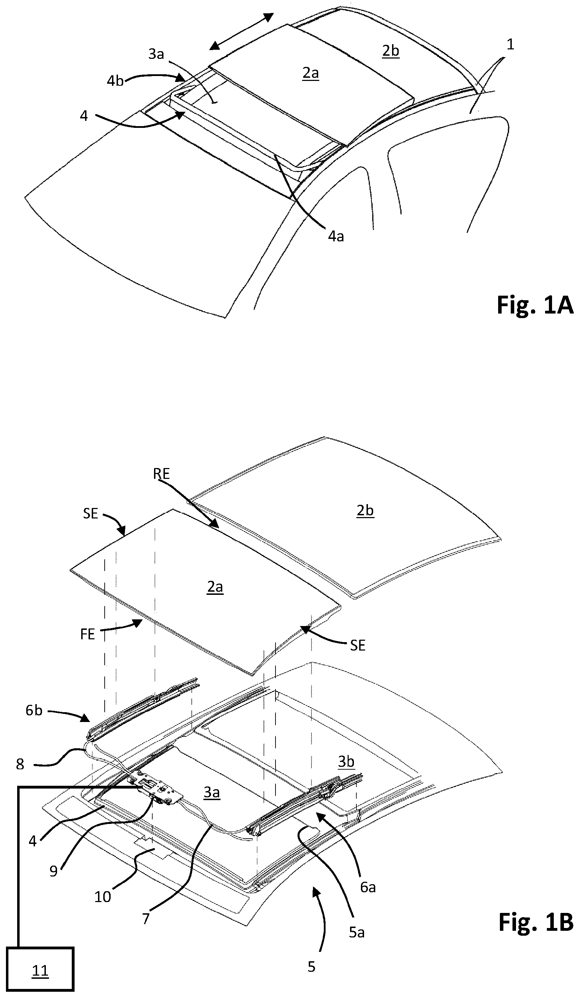

Fig. 1A illustrates a vehicle roof 1 having an open roof assembly arranged therein. The open roof assembly comprises a moveable panel 2a and a fixed panel 2b. The moveable panel 2a is also referred to as a closure member, since the moveable panel 2a is moveable over a first roof opening 3a such to enable to open and to close the first roof opening 3a. A wind deflector 4 is arranged at a front side of the first roof opening 3a.

In the illustrated embodiment, the moveable panel 2a may be in a closed position, which is a position wherein the moveable panel 2a is arranged over and closes the first roof opening 3a and thus usually is arranged in a plane of the vehicle roof 1. Further, the moveable panel 2a may be in a tilted position, which is a position wherein a rear end RE of the moveable panel 2a is raised as compared to the closed position, while a front end FE of the moveable panel 2a is still in the closed position. Further, the moveable panel 2a may be in an open position, which is a position wherein the moveable panel 2a is slid open and the first roof opening 3a is partly or completely exposed.

It is noted that the illustrated vehicle roof 1 corresponds to a passenger car. The present invention is however not limited to passenger cars. Any other kind of vehicles that may be provided with a moveable panel are contemplated as well.

Fig. 1B illustrates the same vehicle roof as shown in Fig. 1A having panels 2a and 2b. In particular, while Fig. 1A shows the open roof assembly in the open position, Fig. 1B is an exploded view of the open roof assembly in a closed position. Further, in this exploded view of Fig. 1B, it is shown that there is a second roof opening 3b. The first and second roof openings 3a, 3b are provided in a frame 5 of the open roof assembly. An edge 5a of the frame 5 defines the first roof opening 3a.

The second roof opening 3b is arranged under the fixed panel 2b such that light may enter a vehicle interior passenger compartment through the fixed panel 2b, presuming that the fixed panel 2b is a glass panel or a similarly transparent panel, for example made of a plastic material or any other suitable material. The second roof opening 3b with a transparent or translucent fixed panel 2b is optional and may be omitted in another embodiment of the open roof assembly.

The wind deflector 4 is commonly a flexible material, e.g. a woven or non-woven cloth having through holes arranged therein or a web or net. The flexible material is supported by a support structure 4a, e.g. a bar-like or tube-like structure, which structure is hingedly coupled, directly or indirectly, to the frame 5 at a hinge 4b.

The wind deflector 4 is arranged in front of the first roof opening 3a and adapts air flow when the moveable panel 2a is in the open position. In its raised position, the wind deflector 4 reduces inconvenient noise due to air flow during driving. When the moveable panel 2a is in the closed position or in the tilted position, the wind deflector 4 is held down below the front end FE of the moveable panel 2a.

Usually, the wind deflector 4 is raised by a spring force when the moveable panel 2a slides to an open position and the wind deflector 4 is pushed down by the moveable panel 2a when the moveable panel 2a slides back into its closed position. In Fig. 1A, the moveable panel 2a is shown in an open position and the wind deflector 4 is shown in a raised position. In Fig. 1B, the moveable panel 2a is shown in a closed position and the wind deflector 4 is correspondingly shown in a position in which it is held down.

Fig. 1B further illustrates a drive assembly having a first guide assembly 6a, a second guide assembly 6b, a first drive cable 7 and a second drive cable 8. The first and second guide assemblies 6a, 6b are arranged on respective side ends SE of the moveable panel 2a and may each comprise a guide and a mechanism. The guide is coupled to the frame 5, while the mechanism comprises moveable parts and is slideably moveable in the guide. The first and the second drive cables 7, 8 are provided between the mechanisms of the respective guide assemblies 6a, 6b and a electric motor 9.

The drive cables 7, 8 couple the electric motor 9 to the mechanisms of the respective guide assemblies 6a, 6b such that upon operating the electric motor 9, the mechanisms start to move. In particular, a core of the drive cable 7, 8 is moved by the electric motor 9 such to push or pull on the mechanisms of the respective guides 6a, 6b. Such a drive assembly is well known in the art and is therefore not further elucidated herein. Still, any other suitable drive assembly may be employed as well without departing from the scope of the present invention. Moreover, in a particular embodiment, an electric motor may be operatively arranged between the respective guides and the respective mechanisms of the guide assemblies 6a, 6b and, in such embodiment, a drive assembly may be omitted completely.

In the illustrated embodiment, the guide assemblies 6a, 6b may start movement with raising the rear end RE of the moveable panel 2a, thereby bringing the moveable panel 2a in the tilted position. Then, from the tilted position, the guide assemblies 6a, 6b may start to slide to bring the moveable panel 2a in the open position. The present invention is however not limited to such embodiment. For example, in another embodiment, the moveable panel 2a may be moveable to a tilted position by raising the rear end RE, while an open position is reached by first lowering the rear end RE and then sliding the moveable panel 2a under the fixed panel 2b or any other structure or element provided behind the rear end RE of the moveable panel 2a. In further exemplary embodiments, the moveable panel 2a may be merely moveable between a closed position and a tilted position or between a closed position and an open position.

In the illustrated embodiment, the electric motor 9 is mounted near or below the front end FE of the moveable panel 2a at a recess 10. In another embodiment, the electric motor 9 may be positioned at any other suitable position or location. For example, the electric motor 9 may be arranged near or below the rear end RE of the moveable panel 2a or below the fixed panel 2b.

A control module 11 is schematically illustrated and is operatively coupled to the electric motor 9. The control module 11 may be any kind of processing module, either a software controlled processing module or a dedicated processing module, like an ASIC, which are both well known to those skilled in the art. The control module 11 may be a stand-alone control module or it may be operatively connected to another control module, like a multipurpose, generic vehicle control module. In yet another embodiment, the control module 11 may be embedded in or be part of such a generic vehicle control module. Essentially, the control module 11 may be embodied by any control module suitable for, capable of and configured for performing operation of the electric motor 9 and thus the moveable roof assembly.

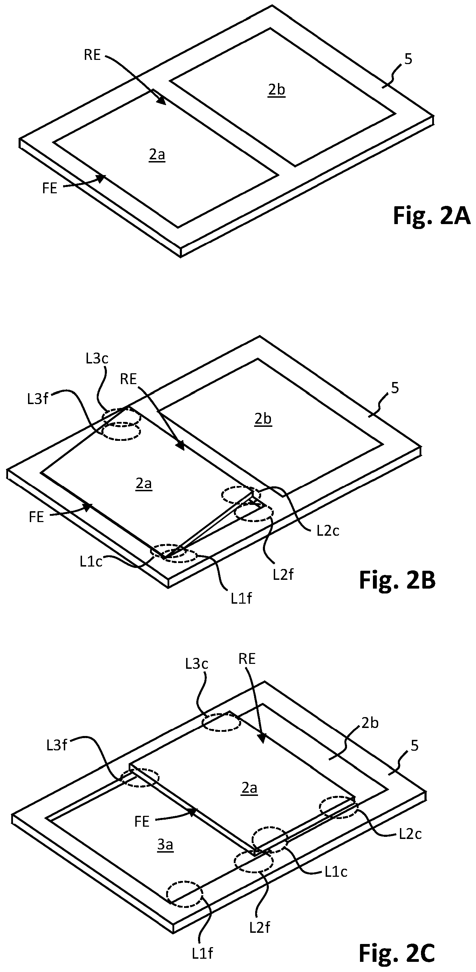

Fig. 2A shows a schematic representation of the open-roof assembly of Fig. 1A. The open-roof assembly comprises a closure member 2a, herein also referred to as the moveable panel 2a, and comprises the fixed panel 2b. Further, the open-roof assembly comprises the frame 5. As indicated in Fig. 2A, the closure member 2a comprises the front end FE and the rear end RE.

In Fig. 2A, the open-roof assembly is in a closed position. In this closed position, the closure member 2a is positioned in a frame plane. The frame plane is a plane defined by the frame 5. Thus, in practice, the frame plane may be curved. In the closed position, the first roof opening 3a is covered and closed by the closure member 2a.

Fig. 2B shows the open-roof assembly of Fig. 2A in a tilted position. In the tilted position, the closure member 2a is rotated at the front end FE and lifted at the rear end RE, thereby creating a gap at the rear end RE. Through the gap, air may flow between an interior compartment of the vehicle and an exterior of the vehicle, for example.

Fig. 2C shows the open-roof assembly of Fig. 2A in an open position. In the open position, the closure member 2a is lifted out of the frame plane and is shifted away from the first roof opening 3a such that the first roof opening 3a is almost completely open.

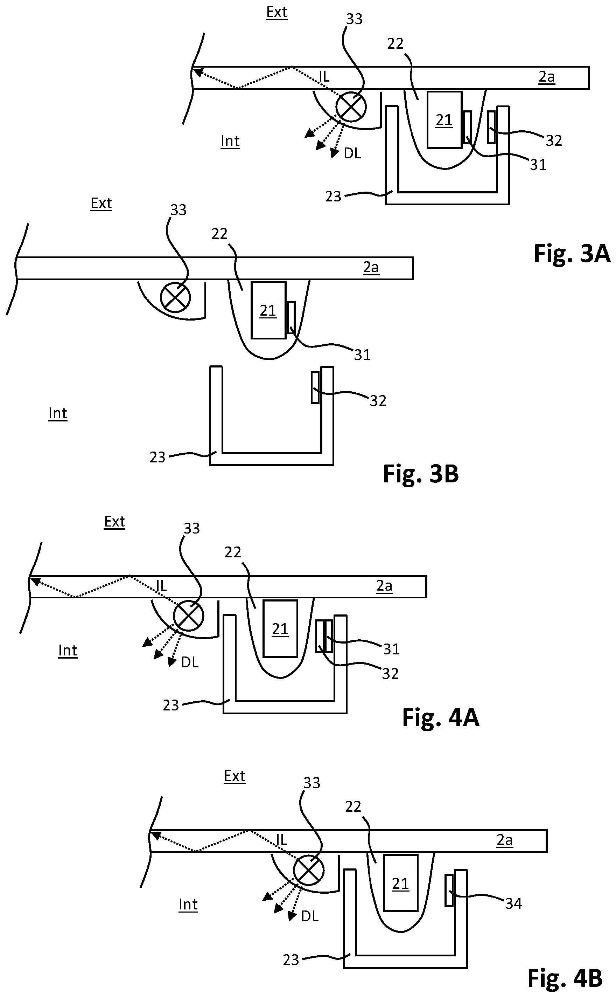

The open-roof assembly is provided with a lighting assembly. A light source of the lighting assembly may be switch on or off depending on the position of the closure member 2a. Thereto, the position of the closure member 2a may be monitored by a suitable switch device, which is illustrated in Figs. 3A - 3B in more detail.

Depending on the desired operation of the lighting assembly, the switch device may be mounted at different positions relative to the frame 5 and the closure member 2a. For example, if the light source may be switched on, when the closure member 2a is in the closed position and the light source needs to be switched of in the tilted position and in the open position, the switch device may be mounted adjacent to or on the rear end of the closure member 2a. In more detail and with reference to Fig. 2B and 2C, the switch device may be mounted in a first configuration at a first rear end position L2c on the closure member 2a or in a second configuration at a first rear frame position L2f on the frame 5.

In another example, if the light source may be switched on, when the closure member 2a is in the closed position or in the tilted position and the light source needs to be switched of in the open position, the switch device may be mounted adjacent to or on the front end of the closure member 2a. In more detail and with reference to Fig. 2B and 2C, the switch device may be mounted in a first configuration at a first front end position L1c on the closure member 2a or in a second configuration at a first front frame position L1f on the frame 5.

For example for additional safety measure, redundancy may be introduced by mounting two switch devices and associated detectable parts. In an embodiment, a first switch device may be mounted on the first rear frame position L2f and on a second rear frame position L3f, while respective detectable parts may be arranged at the first rear end position L2c and at a second rear end position L3c. In this embodiment, when one of the two switch devices detects absence of the detectable part, the light source may be switched off. If one of the switches would fail, the light will still be switched off, when the closure member is in the tilted position or in the open position. In another embodiment, if a failing switch device behaves as a switch device always detecting absence of the detectable part, the light may still be switched on, when one of the two switch devices detects presence of the respective detectable part. In yet another embodiment, when the two switch devices provide a different detection result, a visual or audible error signal may be given.

The operation of the switch device is illustrated in and discussed in relation to Figs. 3A - 3B hereinafter.

Fig. 3A shows a frame part 23 and a closure member 2a in a closed position. The closure member 2a comprises a support frame 21. The support frame 21 may comprise steel or another ferrometal comprising composition. The support frame 21 may be covered by a suitable plastic or rubber-like composition 22 as well known in the art.

The closure member 2a further comprises a light source 33, which is a part of a lighting assembly. The lighting assembly further comprises a switch device 32 and a detectable part 31. In this example that is not part of the present invention, the switch device 32 is a Hall sensor and the detectable part 31 is a magnetic element. The presence of the magnetic element 31 in front of the Hall sensor 32 is detectable by the Hall sensor 32. In the illustrated closed position, the Hall sensor 32 detects the presence of the magnetic element 31 and, thus, it is determined that the closure member 2a is in the closed position, allowing the lighting assembly to operate the light source 33.

In the illustrated embodiment, the light source 33 is arranged on a transparent panel, e.g. a glass or plastic panel, which forms a main component of the closure member 2a. Light emitted by the light source 33 may be direct light DL, directly illuminating an interior Int of the vehicle or the light may be emitted into the transparent panel as indirect light IL. The indirect light IL may travel through the transparent composition of the transparent panel and may couple out of the transparent panel at another location. Such indirect lighting is well known in the art and is not further elucidated herein. In another embodiment, the light source may be mounted on the frame part 23, for example, either for direct lighting or for indirect lighting by reflection against the closure member 2a.

Fig. 3B shows the example of Fig. 3A, wherein the closure member 2a is in a tilted or open position. The detectable part 31 is moved with the closure member 2a out of the frame plane. The detectable part 31 is thus not in front of the switch device 32 and the switch device 32 switches off the operation of the light source 33. No light is emitted by the light source 33 as long as the detectable part 31 is not in front of the switch device 32, i.e. as long as the closure member 2a is in the tilted position or in the open position.

Fig. 4A illustrates an embodiment according to the invention, wherein the main configuration of the open-roof assembly is similar to the configuration of the open-roof assembly of Figs. 3A - 3B, but the switch device 32 and the detectable part are differently configured. In this embodiment, the detectable part is the support frame 21 comprising a ferrometal composition. The switch device comprises a Hall sensor 32 and, in the illustrated closed position, the support frame 21 is in front of the switch device. The switch device also comprises a magnetic element 31 that is positioned at an opposite side of the Hall sensor 32. In such configuration, the switch device is enabled to detect the presence of the ferrometal composition in front of the switch device.

Fig. 4B shows another example that is not part of the present invention, wherein the main configuration of the open-roof assembly is similar to the configuration of the open-roof assembly of Figs. 3A - 3B, but a switch device 34 and the detectable part are different. In this example, the switch device 34 is a capacitive or an inductive sensor. Such sensors are cost-effective sensors that are well known in the art for detecting presence of elements. In this example, the switch device 34 may be configured to detect the presence of the ferrometal comprising support frame 21, in case of an inductive sensor. In case of a capacitive sensor, the presence of the plastic or rubber-like composition 22 covering the support frame 21 may be detected instead or as well.

While in the examples and embodiments of Figs. 3A - 3B and 4A - 4B the respective switch devices 32, 34 are mounted on the frame part 23, the switch devices 32, 34 may alternatively be mounted on the closure member 2a and be configured to detect the frame part 23 as the detectable part or a detectable part like the magnetic element 31 may be mounted on the frame part 23.

Further, the terms and phrases used herein are not intended to be limiting, but rather to provide an understandable description of the invention. The terms "a" or "an", as used herein, are defined as one or more than one. The term plurality, as used herein, is defined as two or more than two. The term another, as used herein, is defined as at least a second or more. The terms including and/or having, as used herein, are defined as comprising (i.e., open language). The term coupled, as used herein, is defined as connected, although not necessarily directly.

## Claims

1. An open-roof assembly for covering or at least partly uncovering an opening (3a) in a vehicle roof (1), the open-roof assembly comprising a moveably arranged closure member (2a), a lighting assembly (33,32,31) and a frame member (23),
wherein the lighting assembly comprises a switch device (32,31) and a light source (33),
the switch device (32,31) being configured and arranged to either
• detect presence of a detectable part (21) of the open-roof assembly relative to the switch device (32,31) without physically contacting the detectable part (21), when the closure member (2a) is in a closed position covering the opening (3a) in the vehicle roof, or
• detect absence of the detectable part (21), when the closure member (2a) is in a position at least partly uncovering the opening (3a) in the vehicle roof (1); and
the lighting assembly (33,32,31) being configured to switch off the light source (33), when the switch device (32,31) detects absence of the detectable part (21),
whereby the switch device comprises a Hall sensor and the detectable part comprises a ferrometal,
**characterized in that**
the switch device (32,31) comprises a magnet (31), wherein the magnetic element (31) is arranged at a first side of the Hall sensor (32) and wherein the detectable part (21) is arranged at a second side of the Hall sensor (32), when the closure member (2a) is in the closed position, the second side being opposite of the first side.

2. The open-roof assembly according to claim 1, wherein the lighting assembly (33,32,31) comprises a further switch device (32, 31) of the same type, the lighting assembly (33,32,31) being configured to switch off the light source (33), when either one of the switch device and the further switch device (32, 31) detects absence of the detectable part (21).

3. The open-roof assembly according to claim 1, wherein the switch device (32, 31) is arranged on the frame member (23), the detectable part (21) being arranged on the closure member (2a).

4. The open-roof assembly according to claim 1, wherein the switch device (32,31) is mounted on the closure member (2a), the detectable part (21) being arranged on the frame member (23).

5. The open-roof assembly according to claim 1, wherein the frame member (23) is arranged in a frame plane and the closure member (2a) is arranged in the frame plane, when the closure member (2a) is in the closed position,
wherein the closure member (2a) comprises a front end (FE) and a rear end (RE),
wherein the closure member (2a) is rotatable at the front end (FE) to move the rear end (RE) out of the frame plane to a tilted position, and
wherein the switch device (32, 31) is arranged either on the rear end (RE) of the closure member (2a) or on an edge section of the frame member (23) adjacent to the rear end (RE) of the closure member (2a), when the closure member (2a) is in the closed position.

6. The open-roof assembly according to claim 1, wherein the frame member (23) is arranged in a frame plane and the closure member (2a) is arranged in the frame plane, when the closure member (2a) is in the closed position,
wherein the closure member (2a) comprises a front end (FE) and a rear end (RE),
wherein the closure member (2a) is rotatable at the front end (FE) to move the rear end (RE) out of the frame plane to a tilted position,
wherein the closure member (2a) is slidable to move the closure member (2a) out of the frame plane to an open position, and
wherein the switch device (32, 31) is arranged either on a front end (FE) of the closure member (2a) or on an edge section of the frame member (23) adjacent to the front end (FE) of the closure member (2a), when the closure member (2a) is in the closed position.

7. A vehicle comprising an open-roof assembly according to claim 1.

## Patentansprüche

1. Offendacheinrichtung zum Abdecken oder zumindest teilweisen Freilegen einer Öffnung (3a) in einem Fahrzeugdach (1), wobei die Offendacheinrichtung ein bewegbar angeordnetes Verschlusselement (2a), eine Beleuchtungseinrichtung (33, 32, 31) und ein Rahmenelement (23) aufweist,
wobei die Beleuchtungseinrichtung eine Schaltvorrichtung (32, 31) und eine Lichtquelle (33) aufweist,
wobei die Schaltvorrichtung (32, 31) konfiguriert und angeordnet ist, um entweder
• das Vorhandensein eines erfassbaren Teils (21) der Offendacheinrichtung relativ zur Schaltvorrichtung (32, 31) zu erfassen, ohne den erfassbaren Teil (21) physisch zu berühren, wenn sich das Verschlusselement (2a) in einer geschlossen-Position befindet, in der es die Öffnung (3a) im Fahrzeugdach abdeckt ist, oder
• das Nichtvorhandensein des erfassbaren Teils (21) zu erfassen, wenn sich das Verschlusselement (2a) in einer Position befindet, in der es die Öffnung (3a) im Fahrzeugdach (1) zumindest teilweise freigibt, und wobei
die Beleuchtungseinrichtung (33, 32, 31) so konfiguriert ist, dass sie die Lichtquelle (33) ausschaltet, wenn die Schaltvorrichtung (32, 31) das Nichtvorhandensein des erfassbaren Teils (21) erfasst, wobei die Schaltvorrichtung einen Hall-Sensor und der erfassbare Teil ein Ferrometall aufweist,
**dadurch gekennzeichnet, dass**
die Schaltvorrichtung (32, 31) einen Magnet (31) aufweist, wobei das Magnetelement (31) auf einer ersten Seite des Hall-Sensors (32) angeordnet ist und wobei der erfassbare Teil (21) auf einer zweiten Seite des Hall-Sensors (32) angeordnet ist, wenn sich das Verschlusselement (2a) in der geschlossen-Position befindet, wobei die zweite Seite zu der ersten Seite entgegengesetzt ist.

2. Offendacheinrichtung gemäß Anspruch 1, wobei
die Beleuchtungseinrichtung (33, 32, 31) eine weitere Schaltvorrichtung (32, 31) desselben Typs aufweist, wobei die Beleuchtungseinrichtung (33, 32, 31) so konfiguriert ist, dass sie die Lichtquelle (33) ausschaltet, wenn entweder die Schaltvorrichtung oder die weitere Schaltvorrichtung (32, 31) das Nichtvorhandensein des erfassbaren Teils (21) erfasst.

3. Offendacheinrichtung gemäß Anspruch 1, wobei
die Schaltvorrichtung (32, 31) an dem Rahmenelement (23) angeordnet ist, wobei der erfassbare Teil (21) an dem Verschlusselement (2a) angeordnet ist.

4. Offendacheinrichtung gemäß Anspruch 1, wobei
die Schaltvorrichtung (32, 31) an dem Verschlusselement (2a) angebracht ist, wobei der erfassbare Teil (21) an dem Rahmenelement (23) angeordnet ist.

5. Offendacheinrichtung gemäß Anspruch 1, wobei
das Rahmenelement (23) in einer Rahmenebene angeordnet ist und das Verschlusselement (2a) in der Rahmenebene angeordnet ist, wenn sich das Verschlusselement (2a) in der geschlossen-Position befindet,
wobei das Verschlusselement (2a) ein vorderes Ende (FE) und ein hinteres Ende (RE) aufweist,
wobei das Verschlusselement (2a) am vorderen Ende (FE) drehbar ist, um das hintere Ende (RE) aus der Rahmenebene in eine gekippt-Position zu bewegen, und
wobei die Schaltvorrichtung (32, 31) entweder am hinteren Ende (RE) des Verschlusselements (2a) oder an einem Randabschnitt des Rahmenelements (23) benachbart zu dem hinteren Ende (RE) des Verschlusselements (2a) angeordnet ist, wenn sich das Verschlusselement (2a) in der geschlossen-Position befindet.

6. Offendacheinrichtung gemäß Anspruch 1, wobei das Rahmenelement (23) in einer Rahmenebene angeordnet ist und das Verschlusselement (2a) in der Rahmenebene angeordnet ist, wenn sich das Verschlusselement (2a) in der geschlossen-Position befindet,
wobei das Verschlusselement (2a) ein vorderes Ende (FE) und ein hinteres Ende (RE) aufweist,
wobei das Verschlusselement (2a) am vorderen Ende (FE) drehbar ist, um das hintere Ende (RE) aus der Rahmenebene in eine gekippt-Position zu bewegen, wobei das Verschlusselement (2a) verschiebbar ist, um das Verschlusselement (2a) aus der Rahmenebene in eine geöffnet-Position zu bewegen, und
wobei die Schaltvorrichtung (32, 31) entweder an einem vorderen Ende (FE) des Verschlusselements (2a) oder an einem Randabschnitt des Rahmenelements (23) benachbart zu dem vorderen Ende (FE) des Verschlusselements (2a) angeordnet ist, wenn sich das Verschlusselement (2a) in der geschlossen-Position befindet.

7. Fahrzeug mit einer Offendacheinrichtung gemäß Anspruch 1.

## Revendications

1. Ensemble toit ouvrant pour recouvrir ou au moins découvrir partiellement une ouverture (3a) dans un toit de véhicule (1), l'ensemble toit ouvrant comprenant un organe de fermeture (2a) agencé mobile, un ensemble éclairage (33, 32, 31) et un organe de cadre (23),
dans lequel l'ensemble éclairage comprend un dispositif d'interruption (32, 31) et une source de lumière (33),
le dispositif d'interruption (32, 31) étant configuré et agencé pour soit
• détecter la présence d'une partie détectable (21) de l'ensemble toit ouvrant par rapport au dispositif d'interruption (32, 31) sans entrer physiquement en contact avec la partie détectable (21), lorsque l'organe de fermeture (2a) est dans une position fermée recouvrant l'ouverture (3a) dans le toit du véhicule, soit
• détecter l'absence de la partie détectable (21), lorsque l'organe de fermeture (2a) est dans une position découvrant au moins partiellement l'ouverture (3a) dans le toit de véhicule (1) ; et
l'ensemble éclairage (33, 32, 31) étant configuré pour éteindre la source de lumière (33), lorsque le dispositif d'interruption (32, 31) détecte l'absence de la partie détectable (21),
dans lequel le dispositif d'interruption comprend un capteur à effet Hall et la partie détectable comprend un métal ferreux,
**caractérisée en ce que**
le dispositif d'interruption (32, 31) comprend un aimant (31), dans lequel l'élément magnétique (31) est agencé au niveau d'un premier côté du capteur à effet Hall (32) et dans lequel la partie détectable (21) est agencée au niveau d'un deuxième côté du capteur à effet Hall (32), lorsque l'organe de fermeture (2a) est dans la position fermée, le deuxième côté étant opposé au premier côté.

2. Ensemble toit ouvrant selon la revendication 1, dans lequel l'ensemble éclairage (33, 32, 31) comprend un dispositif d'interruption supplémentaire (32, 31) du même type, l'ensemble éclairage (33, 32, 31) étant configuré pour éteindre la source de lumière (33), lorsque l'un ou l'autre parmi le dispositif d'interruption et le dispositif d'interruption supplémentaire (32, 31) détecte l'absence de la partie détectable (21).

3. Ensemble toit ouvrant selon la revendication 1, dans lequel le dispositif d'interruption (32, 31) est agencé sur l'organe de cadre (23), la partie détectable (21) étant agencée sur l'organe de fermeture (2a).

4. Ensemble toit ouvrant selon la revendication 1, dans lequel le dispositif d'interruption (32, 31) est monté sur l'organe de fermeture (2a), la partie détectable (21) étant agencée sur l'organe de cadre (23).

5. Ensemble toit ouvrant selon la revendication 1, dans lequel l'organe de cadre (23) est agencé dans un plan de cadre et l'organe de fermeture (2a) est agencé dans le plan de cadre, lorsque l'organe de fermeture (2a) est dans la position fermée,
dans lequel l'organe de fermeture (2a) comprend une extrémité avant (FE) et une extrémité arrière (RE),
dans lequel l'organe de fermeture (2a) est rotatif à l'extrémité avant (FE) pour mettre en mouvement l'extrémité arrière (RE) hors du plan de cadre vers une position inclinée, et
dans lequel le dispositif d'interruption (32, 31) est agencé soit sur l'extrémité arrière (RE) de l'organe de fermeture (2a) soit sur une section de bord de l'organe de cadre (23) adjacente à l'extrémité arrière (RE) de l'organe de fermeture (2a), lorsque l'organe de fermeture (2a) est dans la position fermée.

6. Ensemble toit ouvrant selon la revendication 1, dans lequel l'organe de cadre (23) est agencé dans un plan de cadre et l'organe de fermeture (2a) est agencé dans le plan de cadre, lorsque l'organe de fermeture (2a) est dans la position fermée,
dans lequel l'organe de fermeture (2a) comprend une extrémité avant (FE) et une extrémité arrière (RE),
dans lequel l'organe de fermeture (2a) est rotatif à l'extrémité avant (FE) pour mettre en mouvement l'extrémité arrière (RE) hors du plan de cadre vers une position inclinée,
dans lequel l'organe de fermeture (2a) est coulissant pour mettre en mouvement l'organe de fermeture (2a) hors du plan de cadre vers une position ouverte, et
dans lequel le dispositif d'interruption (32, 31) est agencé soit sur une extrémité avant (FE) de l'organe de fermeture (2a), soit sur une section de bord de l'organe de cadre (23) adjacente à l'extrémité avant (FE) de l'organe de fermeture (2a), lorsque l'organe de fermeture (2a) est dans la position fermée.

7. Véhicule comprenant un ensemble toit ouvrant selon la revendication 1.
